(19) Europäisches Patentamt / European Patent Office / Office européen des brevets

(11) **EP 2 225 119 B1**

(12) **EUROPEAN PATENT SPECIFICATION**

(45) Date of publication and mention
of the grant of the patent:
**09.04.2014 Bulletin 2014/15**

(51) Int Cl.:
**B60K 6/405** (2007.10)     **B60K 6/48** (2007.10)
**B60R 13/08** (2006.01)     **H05K 7/20** (2006.01)

(21) Application number: **08712745.2**

(22) Date of filing: **26.02.2008**

(86) International application number:
**PCT/SE2008/000160**

(87) International publication number:
**WO 2009/082313 (02.07.2009 Gazette 2009/27)**

(54) **HYBRID VEHICLE POWERTRAIN**

HYBRIDFAHRZEUGANTRIEBSSTRANG

GROUPE PROPULSEUR HYBRIDE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **20.12.2007 PCT/SE2007/001149**

(43) Date of publication of application:
**08.09.2010 Bulletin 2010/36**

(73) Proprietor: **Volvo Lastvagnar AB
405 08 Göteborg (SE)**

(72) Inventors:
• **STERVIK, Hans
S-442 71 Kärma (SE)**
• **ALM, Ivar
S-430 90 Öckerö (SE)**

(74) Representative: **Fröhling, Werner Otto
Volvo Technology Corporation
Corporate Patents 06820, M1.7
405 08 Göteborg (SE)**

(56) References cited:
**EP-A1- 0 131 856     EP-A1- 0 921 291
EP-A2- 1 049 235     WO-A1-2004/037594
DE-A1- 10 204 592     DE-A1-102005 003 881
US-A1- 2004 150 271     US-B1- 6 318 329**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD OF THE INVENTION:

The present invention relates to a hybrid vehicle power train according to preamble of claim 1.

BACKGROUND OF THE INVENTION:

The need to reduce fossil fuel consumption and emissions in vehicles powered by an internal combustion engine (ICE) is well known. Vehicles powered by electric motors attempt to address these needs. However, electric vehicles have limited range and limited power capabilities and need substantial time to recharge their batteries. An alternative solution is to combine both an ICE and electric traction motor into one vehicle. Such vehicles are typically called Hybrid Electric Vehicles (HEVs). See for example, US5343970.

The HEV is described in a variety of configurations. Many HEV patents disclose systems in which an operator is required to select between electric and internal combustion operation. In other configurations, the electric motor drives one set of wheels and the ICE drives a different set.

Other, more useful, configurations have developed. For example, a Series Hybrid Electric Vehicle (SHEV) configuration is a vehicle with an engine (most typically an ICE) connected to an electric motor called a generator. The generator, in turn, provides electricity to a battery and another motor, called a traction motor. In the SHEV, the traction motor is the sole source of wheel torque. There is no mechanical connection between the engine and the drive wheels.

A Parallel Hybrid Electrical Vehicle (PHEV) configuration has an engine (most typically an ICE) and an electric motor that together provide the necessary wheel torque to drive the vehicle. Additionally, in the PHEV configuration, the motor can be used as a generator to charge the battery from the power produced by the ICE. The PHEV has usually a transmission between the ICE and drive wheels of the vehicle in order to be able to alter gear ratio between the ICE and the drive wheels and also in many cases between the electric motor and the drive wheels.

A Parallel/Series Hybrid Electric Vehicle (PSHEV) has characteristics of both PHEV and SHEV configurations and is typically known as a "powersplit" configuration. In the PSHEV, the ICE is mechanically coupled to two electric motors in a planetary gearset transaxle. A first electric motor, the generator, is connected to a sun gear. The ICE is connected to a carrier. A second electric motor, a traction motor, is connected to a ring gear (output) via additional gearing in a transaxle. Engine torque powers the generator to charge the battery. The generator can also contribute to the necessary wheel (output shaft) torque. The traction motor is used to contribute wheel torque and to recover braking energy to charge the battery if a regenerative braking system is used.

The desirability of combining an ICE with an electric motor is clear. The ICE's fuel consumption and emissions are reduced with no appreciable loss of vehicle performance or range. Nevertheless, there remains a substantial opportunity to develop ways to optimize HEV operation.

One area of development is maintaining the desired operating temperature of the HEV components. A cooling system maintains optimal component operation and performance. Overheated components adversely affect efficiency and may eventually cause component failure.

A typical prior art cooling system for an ICE vehicle has a coolant fluid in an enclosed loop that passes through certain vehicle components and a heat exchanger (radiator). A heater core is also typically added to vent engine heat into the passenger compartment as desired. The engine and transmission components typically require cooling from a liquid cooling system. As the coolant circulates through these components in the closed loop, it absorbs heat that is released as the coolant passes through the radiator and heater core.

Coolant flow in the prior art cooling system is typically controlled by a pump driven front-end accessory drive (FEAD). As engine speed increases, the speed of the pump also increases allowing more coolant flow through the system. Additionally, a thermostat within the loop only allows coolant flow through the radiator after the coolant temperature reaches a level at which the engine temperature has stabilized and is considered "warmed up."

Though simple and reliable, the prior art coolant control system comprising a pump and a thermostat is inadequate for HEVs. For example, the HEV has additional components that require cooling, such as a power electronics unit. Further, the prior art coolant pump does not function when the engine is off. Thus, the typical vehicle accessories driven by the FEAD (including the coolant pump, air conditioning, and power steering) in a conventional vehicle must be powered by an alternate source in the HEV to maintain their functionality when the engine is not running.

The cooling system of a prior art transmission usually comprises a predetermined amount of cooling oil contained in the transmission housing. Some of the gear wheels of the transmission are arranged to be in contact with the cooling oil. When the gear wheels of the transmission rotate during operation, the cooling oil is splashed around in the transmission housing, making the oil coming into contact with basically all parts inside the transmission housing. The oil evens the heat build up in the transmission and contributes to heat being conducted to the transmission housing. The transmission housing can be cooled by ambient air. There are also transmission cooling systems where the oil is circulated by a pump through cooling channels inside the transmission housing and outside the transmission housing to a heat exchanger.

In a heavy HEV, such as a truck more than 5 tonnes it is common for an electric motor/generator to have a performance capacity of more than 100 kW. A power electronics unit for such a relatively powerful electric motor/generator produces a lot of heat during operation that has to be cooled in order to secure the endurance of the electronic components in the power electronics unit. Depending on the specification of the electronic components the maximum allowable temperature varies. Electronic components with less heat resistance are cheap and can have a maximum operative temperature of, for example, 60 degrees Celsius. If the electronic components are specified to withstand temperatures of several hundred degrees Celsius then usually no cooling of the power electronics unit is needed. On the other hand such electronic components are expensive. In the future the power electronics unit is expected to shrink in size due to technical development. The demand for cooling will probably increase since the electronic components will be more densely packed and the electric power handled by the power electronics unit will increase concurrently with the use of more powerful electric motor/generators used in future HEV.

US2004/0134695 discloses a vehicle power train with a combustion engine, a gearbox and an Integrated Starter/Generator (ISG) arranged between the combustion engine and the gearbox. Thus, this document does not disclose a HEV, still, in one embodiment disclosed the power electronics unit of the ISG is arranged on the gearbox. The power demand of an ISG is usually between 1 to 5 kW. The power electronics unit of the ISG is, thus, relatively small and handles a relatively low power. The need for cooling is relatively small. Further, this document discloses an embodiment where a cooling system of the engine also is used for cooling the power electronics unit, when the power electronics unit is arranged on the engine. Only two standard mounting points for a conventional ring gear starter are used when the power electronics unit is mounted on the engine. There is also disclosed a plug in connection between the power electronics unit and the ISG.

Noise from a vehicle power train is always an issue. The transmission components of a vehicle transmission contributes to the increase of noise when in operation. A step geared transmission, especially when gear changing frequently, can cause slamming and rattling, which can be disturbing for the environment.

A known noise damping solution is to arrange a relatively thin plate on the outside of the transmission housing. The fixing point of the plate extends around the whole periphery of one side of the plate. Said transmission outside, said plate side and said fixing point enclose a compartment comprising a medium, such as air, with high noise damping capabilities. The fixing point as such can be of a noise damping material such as rubber or the like.

The object of the present invention is to make a HEV more space effective with a minimal amount of components. A further object of the present invention is to contribute to a simple and effective installation of a cooling arrangement of power electronics unit in the HEV powertrain and to contribute to noise reduction of said vehicle.

## SUMMARY OF THE INVENTION

The power train according to the invention is a hybrid vehicle power train comprising a combustion engine arranged for propulsion, and an electric motor/generator arranged for propulsion, a transmission with a transmission housing, said transmission is arranged to adapt gear ratio between at least one of said propulsion units and driven vehicle wheels, said motor/generator is arranged to exchange electric power with a power electronics unit, a cooling arrangement comprising cooling channels for cooling at least said power electronics unit. The invention is characterized in that said power electronics unit is shaped substantially as a plate, where a first biggest cross-sectional area of said plate is extended substantially along and substantially within a first transmission side of said transmission housing and covering at least a part of said first transmission side, said power electronics unit is fixed to said first transmission side and/or outside surface of said motor/generator with at least one first attachment point. And where all attachment points have a total thermal conductance corresponding to more than 10 degrees temperature difference on a Kelvin-scale between said power electronics unit and outside surface of said first transmission side and/or outside surface of said motor/generator for 5kW of heat originating from one side of said attachment point.

WO2004037594 discloses a further prior art solution comprising the features of the preamble of claim 1; a hybrid vehicle power train, said hybrid vehicle powertrain comprising a combustion engine arranged for propulsion, and an electric motor/generator arranged for propulsion, a transmission with a transmission housing, said transmission is arranged to adapt gear ratio between at least one of said propulsion units and driven vehicle wheels, said motor/generator is arranged to exchange electric power with a power electronics unit, a cooling arrangement comprising cooling channels for cooling at least said power electronics unit.

The advantage with the hybrid vehicle powertrain according to the invention is increased space efficiency of the power electronics unit installation at the same time as the thermal conductance of the attachment point/-s has/have been decreased, which increases the performance of the cooling arrangement of the power electronics unit.

According to one embodiment of the hybrid vehicle powertrain according to the invention said electric motor/generator and said power electronics unit are connected and fixed to each other to form a first unit, and where said connection is said first attachment point formed by a plug in connection. This embodiment decreases the number of components.

According to one embodiment of the hybrid vehicle powertrain according to the invention said power electronics unit is also attached to said first transmission side via at least a second attachment point made of a material with low thermal conductance. The advantage is that the carrying performance of the power electronics unit is increased still with low total thermal conductance at the attachment points.

According to one embodiment of the hybrid vehicle powertrain according to the invention, said plug in connection is arranged to transmit at least one of or both of a cooling media for said cooling arrangement and electric power between said motor/generator and said power electronics unit. This decreases the number of components.

According to one embodiment of the hybrid vehicle powertrain according to the invention, said power electronics unit plate is arranged to cover said first transmission side in such a way as to damp noise originating from said transmission.

According to one embodiment of the hybrid vehicle powertrain according to the invention, said second attachment point is extended around the periphery of a side of said power electronics unit facing the transmission, and where said first transmission side, said power electronics unit side and said second attachment point enclose a compartment comprising a medium with low thermal conductance and high noise damping capabilities. This decreases the number of components at the same time as the functionalities of the installation increases.

According to one embodiment of the hybrid vehicle powertrain according to the invention, said first and second attachment points are of materials with high noise damping capabilities.

According to one embodiment of the hybrid vehicle powertrain according to the invention, said power electronics unit plate comprises said power electronics unit with noise damping material and in an extended part only of a noise damping material, said extended part being arranged in order to better cover said first transmission side. The extended part increases especially the noise reduction capabilities of the installation.

According to one embodiment of the hybrid vehicle powertrain according to the invention, a second electric motor/generator with a second power electronics unit are arranged in connection to said transmission and which together form a second unit via a second plug in connection, and where said second power electronics unit is arranged along a second transmission side of said transmission housing. The advantage is that the number of components can be decreased even further and the noise reduction capabilities can be kept on a high level without any additional noise reducing components.

According to one embodiment of the hybrid vehicle powertrain according to the invention a hose for transmitting cooling media is connected to said power electronics unit on substantially an opposite side of where said plug in connection is arranged. This embodiment is characterized in that said second attachment point is formed of a part of said hose and a cooling hose holder for holding said hose, and where said hose holder is attached to said transmission housing. The advantage is that performance of carrying the power electronics unit can be increased without increase of the number of components and still with low total thermal conductance at the attachment points.

According to one embodiment of the hybrid vehicle powertrain according to the invention said power electronics unit is only fixed to said first transmission side with at least one of said first attachment point. Said first attachment point can be of a screw-nut type, with a relatively small cross-sectional area. This embodiment can also be combined with a hose for transmitting cooling medium that is connected to said power electronics unit on substantially an opposite side of where said screw-nut type attachment point is arranged, and where said hose and a cooling hose holder for holding said hose forms a further attachment point, and where said hose holder is attached to said transmission housing.

In a further embodiment of said invention a second attachment point can be combined with said screw-nut type attachment point, and where said second attachment point is extended around the periphery of a side of said power electronics unit facing the transmission, and where said first transmission side, said power electronics unit side and said second attachment point enclose a compartment comprising a medium with low thermal conductance and high noise damping capabilities. This embodiment can also be combined with a hose for transmitting cooling medium that is connected to said power electronics unit on substantially an opposite side of where said screw-nut type attachment point is arranged, and where said hose and a cooling hose holder for holding said hose forms a further attachment point, and where said hose holder is attached to said transmission housing.

Further advantageous embodiments of the invention emerge from the dependent patent claims following patent claim 1.

BRIEF DESCRIPTION OF THE DRAWING

The present invention will be described in greater detail below with reference to the accompanying drawings which, for the purpose of exemplification, shows further preferred embodiments of the invention and also the technical background, and in which:

Figures 1a and 1b diagrammatically shows a PHEV power train in two different views of an embodiment of the invention.

Figures 2a and 2b diagrammatically shows a PHEV power train in two different views of an embodiment of the invention.

Figures 8a and 8b diagrammatically shows a PHEV power train in two different views of an embodiment of the invention.

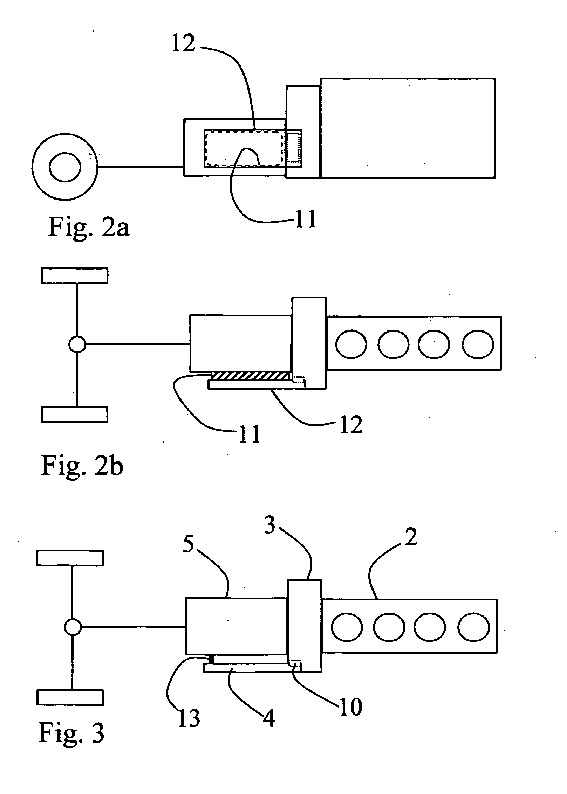

Figures 3 to 7 and 10 diagrammatically show a top view of further five different PHEV power trains and embodiments of the invention.

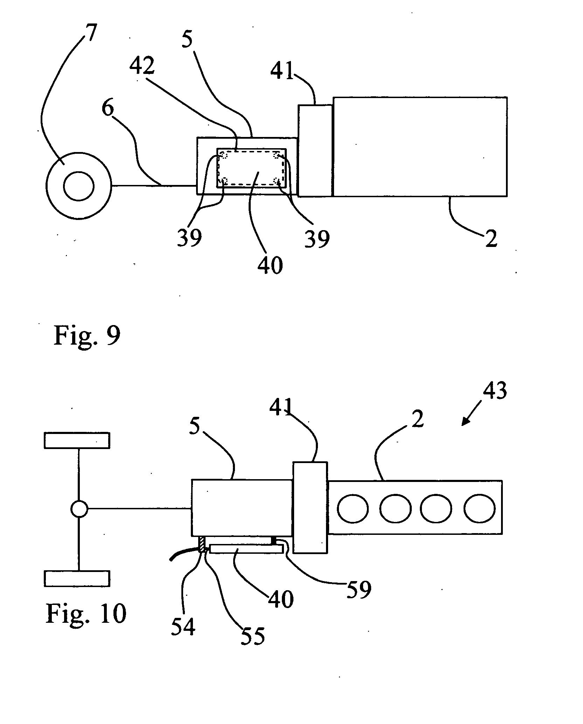

Figure 9 diagrammatically shows a side view of another PHEV power train and embodiments of the invention.

DESCRIPTION OF THE INVENTION

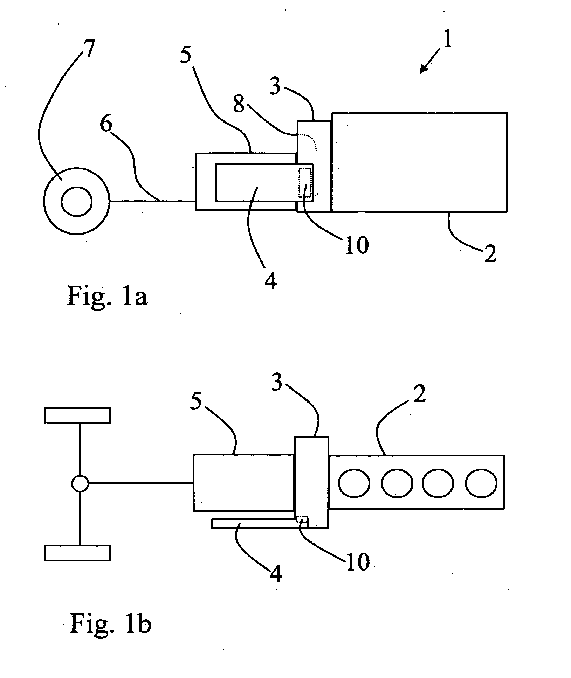

Figure 1a and 1b show a PHEV power train 1 comprising a first embodiment of the invention. The HEV power train comprises a combustion engine 2, an electric motor/generator 3 with a power electronics unit 4, a transmission 5, a propeller shaft 6 and drive wheels 7.

Arranged mainly coaxially inside of said electric motor/generator 3 is a clutch 8 (not disclosed), which is arranged to transmit torque between the engine 2 and the transmission 5 and which can be engaged or disengaged depending of vehicle condition. The transmission can be a step geared transmission with several gear ratios.

According to the invention the power electronics unit 4 is formed as a relatively thick space efficient plate arranged along one side of the transmission 5. The outer of the transmission housing can have a cubic form or a cylinder form or something in between. When the power electronics unit is said to be arranged along a side of said transmission housing, this side is defined as the projection of the outer contour of the transmission housing. Thus, said projection can be a cross sectional plane of the transmission housing along which said power electronics unit is arranged. In the in figure 1a and 1b showed embodiment only one attachment point is used for fixing the power electronics unit to the side of the transmission. This attachment point is formed by a plug in connection 10 arranged to fix the power electronics unit to the electric motor/generator 3. The plug in connection is arranged to have a thermal conductance corresponding to more than 10 degrees temperature difference on a Kelvin-scale between said power electronics unit and outside surface of said motor/generator for 5kW of heat originating from one side of said attachment point.

$$\text{Where thermal conductance} = Q/\Delta T = (k \cdot A)/L,$$

and where

Q = heat flow rate,
$\Delta T$ = temperature difference,
k = thermal conductivity,
A = area,
L = distance

The SI-unit for thermal conductance is $W \cdot K^{-1}$.

Thus, the plug in connection is designed in such a way as to have a relatively low thermal conductance. This can be achieved for example by choosing materials for the plug in connection having low thermal conductance. Examples of materials with low thermal conductance are ceramics, plastics or rubber.

Further, the power electronics unit comprises electronics that has to be cooled in order to secure functionality. A cooling arrangement (not showed) in the power electronics unit is connected to a second cooling arrangement (not showed) of said electric motor/generator via the plug in connection 10, thus integrating the power electronics unit and the electric motor/generator to form a unit. The plug in connection can also comprise necessary electric connections between the power electronics unit 4 and the electric motor/generator 3 or only one of said electric connections and said cooling arrangement connection. Said cooling arrangements form together with other necessary, not shown components, a cooling system of the power electronics unit and the motor/generator.

Figures 2a and 2b disclose a similar HEV power train as in figures 1a and 1b. In the embodiment of figures 2a and 2b a second attachment point, besides the plug in connection, has been added and is arranged to connect the transmission housing and the power electronics unit. Besides low thermal conductance this second attachment point together with the power electronics unit plate 12 is designed to damp noise originating from said transmission. This is achieved by the second attachment point extending around the periphery of the side of the power electronics unit facing the side of the transmission (see dashed line in figure 2a). Thus, the transmission side, the side of the power electronics unit and the second attachment point are enclosing a compartment comprising a medium with low thermal conductance and high noise damping capabilities. This medium can for example be air. The second attachment point as such can be made of for example rubber. According to one embodiment of the invention this second attachment point is not design for fixing the power electronics unit to the transmission, thus the second attachment point has a very low carrying functionality. The main carrying functionality of the power electronics unit lies in this embodiment on the plug in connection. In a further embodiment this second attachment point as disclosed in figures 2a and 2b can have a carrying functionality. In such an embodiment the second attachment point is made stiffer, for example with stiffer material or a composite, comprising metal parts and parts made of a material with low thermal conductance and high noise reduction. In order to allow carrying performance to the second attachment point, said attachment point can be fixed to the transmission side and to the power electronics unit in a known manner, with for example different screw/nut solutions, vulcanization etc.

Figure 3 discloses a similar PHEV power train as in figures 1a and 1b. The only difference is that another variant of a second attachment point 13 has been added that has a power electronics unit carrying functionality with low thermal conductance. This variant of the second attachment point 13 can for example comprise of a bushing made of a material with low thermal conductance. The transmission housing and the power electronics unit can each of them be equipped with corresponding flanges (not shown) to which the bushing can be attached by vulcanization and/or screw/nut arrangement (not shown). In one embodiment there can be more than one of this variant of the second attachment point 13. Preferably such an attachment point is arranged substantially on the opposite side of the plug in connection side of the power electronics unit in order to better balance the carrying performance between the plug in connection 10 and this variant of the second attachment point 13. This second attachment point can also be made of a composite (for example metal and a material with low thermal conductance) with a thermal conductance corresponding to more than 10 degrees temperature difference on a Kelvin-scale between said power electronics unit and outside surface of said transmission for 5kW of heat originating from one side of said second attachment point.

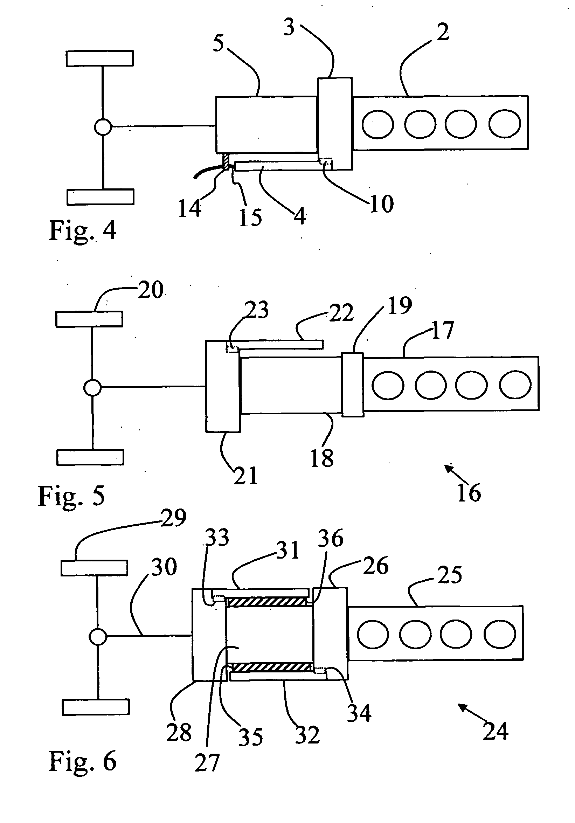

Figure 4 discloses a similar PHEV power train as in figure 3, i. e. figure 4 discloses a third variant of a second attachment point that has power electronics unit carrying functionality and low thermal conductance. This third variant of a second attachment point comprises basically of a part of a hose 15 and a hose holder 14. Said hose can be a cooling hose for transmitting cooling media from a pump and a cooler to the power electronics unit cooling arrangement. The hose holder is fixed to the transmission housing and holding the hose in a fixed position. Thus, this hose holder and hose configuration if made sufficiently strong and stiff can have power electronics unit carrying functionality. Further, at least one of the hose holder or the hose is made of a material with low thermal conductance. In a further embodiment of the invention there can be more than one hose with a hose holder attached to the side of the power electronics unit and attached to the transmission housing. Thus, there can be more than one of this third variant of a second attachment point. As can be seen in figure 4 the hose 15 is connected to said power electronics unit 4 on substantially an opposite side of where said plug in connection 10 is arranged. This will better balance the carrying performance between the plug in connection 10 and this third variant of the second attachment point formed of hose 15 and hose holder 14.

Figure 5 discloses a PHEV power train 16, where a combustion engine 17 is connected to an input shaft (not shown) of a stage geared transmission 18 via a clutch 19. The transmission 18 is further connected to driven wheels 20 via an electric motor/generator 21 attached at an output shaft (not shown) of the transmission 18. The electric motor/generator 21 with its power electronics unit 22 is attached to one end of the transmission housing. Said power electronics unit is attached to the electronic motor/generator via a plug in connection 23 with the same essential features according to the invention as mentioned in the preceding embodiments. In further embodiments of the embodiment shown in figure 5 the features of a second attachment point can be used in a similar way as in the embodiments shown in figures 2a, 2b, 3 and 4.

Figure 6 discloses an embodiment of the invention based on a combination of the embodiments mentioned in relation to figures 2a, 2b and 5. Thus, this power train 24 comprises besides a combustion engine 25, a clutch (not shown) coaxially arranged inside of a first electric motor/generator 26, a step geared transmission 27, a second electric motor/generator 28 connected to an output shaft (not shown) of the transmission and driven wheels 29 connected to the second electric motor/generator 28 via for example a propeller shaft 30. The to electric motor/generators have each of them a power electronics unit 31 and 32 arranged in the corresponding way as in the embodiments of figures 5, 2a and 2b, i. e. with plug in connections 33 and 34. Further, both plug in connections 33 and 34 have a second attachment point 35 and 36 corresponding to the second attachment point explained above in connection to the embodiment disclosed by the figures 2a and 2b, i. e. with noise reduction functionality and low heat conductance. The power electronics units 31 and 32 are arranged on each side of the transmission 27.

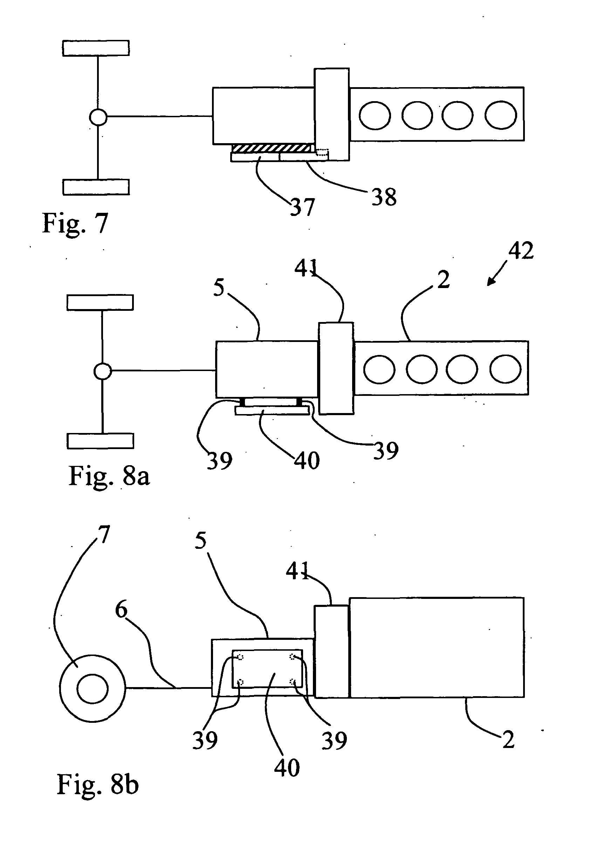

Figure 7 discloses a similar HEV power train as in figures 2a and 2b. Here said power electronics unit plate comprises said power electronics unit 38 with noise damping material and in an extended part 37 only of a noise damping material. The extended part 37 is fixed to the power electronics unit 38 and arranged in order to better cover said first transmission side in order to increase noise reduction. This embodiment can also be applied to the embodiment shown in figure 6.

Figure 8a and 8b disclose a HEV power train 42 similar to the one in figure 3. According to the invention also a power electronics unit 40, as in the above described embodiments, is formed as a relatively thick space efficient plate arranged along one side of the transmission 5. The main difference is that the embodiment of figure 8a and 8b does not have any plug in connection. Thus the motor/generator 41 is slightly modified compared to the one shown in figure 3. Instead of a power electronics unit being connected to the electric/motor via said plug in connection (as in figure 3), the power electronics unit 40 of the embodiment in figures 8a and 8b is somewhat shorter and is, for example, near the corners of the power electronics unit attached to the transmission housing of the transmission 5. In the shown example the attachment points 39 have a relatively small cross-sectional area, compared to the power electronics unit, and can be embodied for example by a screw-nut arrangement made of a material having a low thermal conductance corresponding to a thermal conductance of more than 10 degrees temperature difference on a Kelvin-scale between said power electronics unit and outside surface of said transmission for 5kW of heat originating from one side of said attachment points 39. In the shown example there is four attachment points 39. The number of attachment points 39 can be more or less than four. The transmission of cooling medium and/or electric power to and from the power electronics unit 40 can be performed in a known manner through hoses and electric wires.

Figure 9 discloses a similar HEV power train as in figures 8a and 8b. In the embodiment of figure 9 a second attachment point 42, besides said above described "screw-nut" attachment points 39, has been added and is arranged to connect the transmission housing and the power electronics unit 40. Besides low thermal conductance this second attachment point 42 together with the power electronics unit plate 40 is designed to damp noise originating from said transmission 5. Said second attachment point 42 is similar to the second attachment point 11 shown in the embodiment of, for example, figure 2a and 2b. Thus, in this embodiment the carrying functionality and low thermal conductance of attachment points 39 are combined with the noise reduction capabilities and low thermal conductance of the second attachment point 42.

Figure 10 discloses a similar HEV power train 43 as in figures 8a and 8b. Figure 10 discloses a variant of an attachment point that has power electronics unit carrying functionality and low thermal conductance and which is similar to the third attachment point 14 and 15 shown in the embodiment of figure 4. Thus, this variant of an attachment point, as described above, comprises of a part of a hose 55 and a hose holder 54, both with low thermal conductance. The hose holder 54 and hose 55 are preferably arranged on the opposite side of the power electronics unit 40 compared to attachment point 59. Thus, a decrease in the number of the attachment points 59 is possible.

In a further not shown embodiment of a HEV power train the attachment points 54, 55 and 59 of the embodiment shown in figure 10 can be combined with the noise damping attachment point 42 of the embodiment shown in figure 9.

The above mentioned inventive features can also be applied to a heavy PSHEV (power split) with several mechanical fixed gear steps in the transmission.

The invention should not be deemed to be limited to the embodiments described above, but rather a number of further variants and modifications are conceivable within the scope of the following patent claims.

## Claims

1.  A hybrid vehicle power train comprising a combustion engine (2, 17, 25) arranged for propulsion, and an electric motor/generator (3, 21, 28, 26, 41) arranged for propulsion, a transmission (5, 18, 27) with a transmission housing, said transmission is arranged to adapt gear ratio between at least one of said propulsion units and driven vehicle wheels (7), said motor/generator is arranged to exchange electric power with a power electronics unit (4, 12, 22, 31, 32, 38, 40), a cooling arrangement comprising cooling channels for cooling at least said power electronics unit, said power electronics unit is shaped substantially as a plate, **characterized in that** a first biggest cross-sectional area of said plate is extended substantially along and substantially within a first transmission side of said transmission housing and covering at least a part of said first transmission side, said power electronics unit is fixed to said first transmission side and/or outside surface of said motor/generator with at least one first attachment point (10, 23, 33, 34, 39), where all attachment points (10, 11, 13, 14, 15, 23, 33, 34, 35, 36, 39, 42, 54, 55, 59) have a total thermal conductance corresponding to more than 10 degrees temperature difference on a Kelvin-scale between said power electronics unit and outside surface of said first transmission side and/or outside surface of said motor/generator for 5kW of heat originating from one side of said attachment point.

2.  A hybrid vehicle power train as in claim 1, **characterized in that** said electric motor/generator and said power electronics unit are connected and fixed to each other to form a first unit, and where said connection is said first attachment point formed by a plug in connection (10, 23, 33, 34).

3.  A hybrid vehicle power train as in claim 2, **characterized in that** said power electronics unit is also attached to said first transmission side via at least a second attachment point (11, 13, 14, 15, 35, 36) made of a material with low thermal conductance.

**4.** A hybrid vehicle power train as in claim 2, **characterized in that** said plug in connection is arranged to transmit at least one of or both of a cooling medium for said cooling arrangement and electric power between said motor/generator and said power electronics unit.

**5.** A hybrid vehicle power train as in claim 2, **characterized in that** said power electronics unit plate (12, 31, 32, 37, 38) is arranged to cover said first transmission side in such a way as to damp noise originating from said transmission.

**6.** A hybrid vehicle power train as in claim 3, **characterized in that** said second attachment point (11, 35, 36) is extended around the periphery of a side of said power electronics unit facing the transmission, and where said first transmission side, said power electronics unit side and said second attachment point enclose a compartment comprising a medium with low thermal conductance and high noise damping capabilities.

**7.** A hybrid vehicle power train as in the preceding claim, **characterized in that** said first and second attachment points are of a material with high noise damping capabilities.

**8.** A hybrid vehicle power train as in one of claims 6 or 7, **characterized in that** said power electronics unit plate comprises said power electronics unit (38) with noise damping material and in an extended part (37) only of a noise damping material, said extended part being arranged in order to better cover said first transmission side.

**9.** A hybrid vehicle power train as in claim 2, **characterized in that** a second electric motor/generator (28) with a second power electronics unit (31) are arranged in connection to said transmission (27) and which together form a second unit via a second plug in connection (33), and where said second power electronics unit is arranged along a second transmission side of said transmission housing.

**10.** A hybrid vehicle power train as in one of claims 3 or 4, where a hose (15) for transmitting cooling medium is connected to said power electronics unit on substantially an opposite side of where said plug in connection (10) is arranged, **characterized in that** said second attachment point is formed of a part of said hose (15) and a cooling hose holder (14) for holding said hose, and where said hose holder is attached to said transmission housing.

**11.** A hybrid vehicle power train as in claim 1, **characterized in that** said power electronics unit is only fixed to said first transmission side with at least one of said first attachment point (39, 59).

**12.** A hybrid vehicle power train as in the preceding claim, **characterized in that** said first attachment point is of a screw-nut type, with a relatively small cross-sectional area.

**13.** A hybrid vehicle power train as in one of claims 11 or 12, **characterized in that** a second attachment point (42) is extended around the periphery of a side of said power electronics unit facing the transmission, and where said first transmission side, said power electronics unit side and said second attachment point enclose a compartment comprising a medium with low thermal conductance and high noise damping capabilities.

**14.** A hybrid vehicle power train as in one of claims 11 to 13, where a hose for transmitting cooling medium is connected to said power electronics unit on substantially an opposite side of where said first attachment point (59) is arranged, **characterized in that** a third attachment point is formed of a part (55) of said hose and a cooling hose holder (54) for holding said hose, and where said hose holder is attached to said transmission housing.

**15.** A hybrid vehicle power train as in one of the preceding claims, **characterized in that** said hybrid vehicle power train is a parallel hybrid electric vehicle power train.

**Patentansprüche**

**1.** Hybridfahrzeugantriebsstrang mit einem Verbrennungsmotor (2, 17, 25), der für einen Antrieb angeordnet ist, und einem elektrischen Motor/Generator (3, 21, 28, 26, 41), der für einen Antrieb angeordnet ist, einem Getriebe (5, 18, 27) mit einem Getriebegehäuse, wobei das Getriebe zur Anpassung eines Übersetzungsverhältnisses zwischen wenigstens einer der Antriebseinheiten und angetriebenen Fahrzeugrädern (7) angeordnet ist, wobei der Motor/Generator für einen Austausch von elektrischer Leistung mit einer Leistungselektronikeinheit (4, 12, 22, 31, 32, 38, 40) angeordnet ist, einer Kühlanordnung, die Kühlkanäle zum Kühlen wenigstens der Leistungselektronikeinheit umfasst, wobei die Leistungselektronikeinheit im Wesentlichen als eine Platte geformt ist,

**dadurch gekennzeichnet**, ein erster größter Querschnittsbereich der Platte sich im Wesentlichen entlang und im Wesentlichen innerhalb einer ersten Getriebeseite des Getriebegehäuses erstreckt und wenigstens einen Teil der ersten Getriebeseite abdeckt, dass die Leistungselektronikeinheit an der ersten Getriebeseite und/oder Außenfläche des Motors/Generators mit wenigstens einer Befestigungsstelle (10, 23, 33, 34, 39) befestigt ist, wobei alle Befestigungsstellen (10, 11, 13, 14, 15, 23, 33, 34, 35, 36, 39, 42, 54, 55, 59) einen Gesamtwärmeleitwert aufweisen, der mehr als 10 Grad Temperaturdifferenz auf einer Kelvin-Skala zwischen der Leistungselektronikeinheit und der Außenfläche der ersten Getriebeseite und/oder Außenfläche des Motors/Generators bei einer Wärme von 5kW entspricht, die von einer Seite der Befestigungsstelle stammt.

2. Hybridfahrzeugantriebsstrang nach Anspruch 1, **dadurch gekennzeichnet, dass** der elektrische Motor/Generator und die Leistungselektronikeinheit verbunden und aneinander befestigt sind, um eine erste Einheit zu bilden, und wobei die Verbindung die erste Befestigungsstelle ist, die durch eine Einsteckverbindung (10, 23, 33, 34) gebildet wird.

3. Hybridfahrzeugantriebsstrang nach Anspruch 2, **dadurch gekennzeichnet, dass** die Leistungselektronikeinheit außerdem an der ersten Getriebeseite über wenigstens eine zweite Befestigungsstelle (11, 13, 14, 15, 35, 36) angebracht ist, die aus einem Material mit geringem Wärmeleitwert hergestellt ist.

4. Hybridfahrzeugantriebsstrang nach Anspruch 2, **dadurch gekennzeichnet, dass** die Einsteckverbindung so konfiguriert ist, dass sie wenigstens eines oder beide von einem Kühlmedium für die Kühlanordnung und von einer elektrischen Leistung zwischen dem Motor/Generator und der Leistungselektronikeinheit überträgt.

5. Hybridfahrzeugantriebsstrang nach Anspruch 2, **dadurch gekennzeichnet, dass** die Leistungselektronikeinheitsplatte (12, 31, 32, 37, 38) so angeordnet ist, dass sie die erste Getriebeseite so abdeckt, dass sie Geräusche dämpft, die von dem Getriebe stammen.

6. Hybridfahrzeugantriebsstrang nach Anspruch 3, **dadurch gekennzeichnet, dass** die zweite Befestigungsstelle (11, 35, 36) sich um den Umfang einer Seite der Leistungselektronikeinheit dem Getriebe zugewandt erstreckt, wobei die erste Getriebeseite, die Seite der Leistungselektronikeinheit und die zweite Befestigungsstelle einen Raum umschließen, der ein Medium mit einem geringem Wärmeleitwert und hohem Geräuschdämpfvermögen enthält.

7. Hybridfahrzeugantriebsstrang nach dem vorhergehenden Anspruch, **dadurch gekennzeichnet, dass** die erste und die zweite Befestigungsstelle aus einem Material mit hohem Geräuschdämpfvermögen hergestellt sind.

8. Hybridfahrzeugantriebsstrang nach einem der Ansprüche 6 oder 7, **dadurch gekennzeichnet, dass** die Leistungselektronikeinheitsplatte die Leistungselektronikeinheit (38) mit geräuschdämpfendem Material und in einem verlängerten Abschnitt (37) nur ein Geräuschdämpfungsmaterial umfasst, wobei der verlängerte Abschnitt angeordnet ist, um die erste Getriebeseite besser abzudecken.

9. Hybridfahrzeugantriebsstrang nach Anspruch 2, **dadurch gekennzeichnet, dass** ein zweiter elektrischer Motor/Generator (28) mit einer zweiten Leistungselektronikeinheit (31) in Verbindung mit dem Getriebe (27) angeordnet ist und zusammen eine zweite Einheit über eine zweite Einsteckverbindung (33) bilden, wobei die zweite Leistungselektronikeinheit entlang einer zweiten Getriebeseite des Getriebegehäuses angeordnet ist.

10. Hybridfahrzeugantriebsstrang nach einem der Ansprüche 3 oder 4, wobei ein Schlauch (15) zur Übertragung eines Kühlmediums mit der Leistungselektronikeinheit bezüglich dem Ort der Steckverbindung (10) auf einer im Wesentlichen entgegengesetzten Seite verbunden ist, **dadurch gekennzeichnet, dass** die zweite Befestigungsstelle von einem Abschnitt des Schlauchs (15) und einem Kühlschlauchhalter (14) zum Halten des Schlauches gebildet wird, wobei der Schlauchhalter an dem Getriebegehäuse angebracht ist.

11. Hybridfahrzeugantriebsstrang nach Anspruch 1, **dadurch gekennzeichnet, dass** die Leistungselektronikeinheit nur an der ersten Getriebeseite mit wenigstens einer ersten Befestigungsstelle (39, 59) befestigt ist.

12. Hybridfahrzeugantriebsstrang nach dem vorhergehenden Anspruch, **dadurch gekennzeichnet, dass** die erste Befestigungsstelle vom Typ Schraube-Mutter ist und eine relativ kleine Querschnittsfläche aufweist.

13. Hybridfahrzeugantriebsstrang einem der Ansprüche 11 oder 12, **dadurch gekennzeichnet, dass** eine zweite Befestigungsstelle (42) sich um den Umfang einer Seite der Leistungselektronikeinheit dem Getriebe zugewandt erstreckt, wobei die erste Getriebeseite, die Seite der Leistungselektronikeinheit und die zweite Befestigungsstelle einen Raum umschließen, der ein Medium mit einem geringen Wärmeleitwert und hohem Geräuschdämpfvermögen enthält.

**14.** Hybridfahrzeugantriebsstrang einem der Ansprüche 11 bis 13, wobei ein Schlauch zur Übertragung eines Kühlmediums mit der Leistungselektronikeinheit bezüglich dem Ort der ersten Befestigungsstelle (59) auf einer im Wesentlichen entgegengesetzten Seite verbunden ist, **dadurch gekennzeichnet, dass** eine dritte Befestigungsstelle von einem Abschnitt (55) des Schlauches und einem Kühlschlauchhalter (54) zum Halten des Schlauchs gebildet wird, wobei der Schlauchhalter an dem Getriebegehäuse angebracht ist.

**15.** Hybridfahrzeugantriebsstrang nach einem der vorhergehenden Ansprüche, **dadurch gekennzeichnet, dass** der Hybridfahrzeugantriebsstrang ein Parallelhybridelektrofahrzeug-Antriebsstrang ist.

**Revendications**

**1.** Groupe motopropulseur de véhicule hybride comprenant un moteur à combustion (2, 17, 25) agencé pour la propulsion, et un moteur/générateur électrique (3, 21, 28, 26, 41) agencé pour la propulsion, une transmission (5, 18, 27) avec un carter de transmission, ladite transmission est agencée pour ajuster un rapport de vitesse entre au moins l'une desdites unités de propulsion et des roues motrices (7) de véhicule, ledit moteur/générateur est agencé pour permettre un échange de puissance électrique avec une unité électronique de puissance (4, 12, 22, 31, 32, 38, 40), un agencement de refroidissement comprenant des canaux de refroidissement destinés à refroidir au moins ladite unité électronique de puissance, ladite unité électronique de puissance est mise essentiellement en forme plaque, **caractérisé en ce que** la première plus grande section en coupe transversale de ladite plaque s'étend essentiellement le long d'un premier côté de transmission dudit carter de transmission et essentiellement à l'intérieur de celui-ci et recouvrant au moins une partie dudit premier côté de transmission, ladite unité électronique de puissance est fixée audit premier côté de transmission et/ou à une surface extérieure dudit moteur/générateur avec au moins un premier point de fixation (10, 23, 33, 34, 39), où tous les points de fixation (10, 11, 13, 14, 15, 23, 33, 34, 35, 36, 39, 42, 54, 55, 59) présentent une conductance thermique totale correspondant à une différence de température supérieure à 10 degrés sur une échelle Kelvin entre ladite unité électronique de puissance et une surface extérieure dudit premier côté transmission et/ou une surface extérieure dudit moteur/générateur pour 5 kW de chaleur provenant d'un côté dudit point de fixation.

**2.** Groupe motopropulseur de véhicule hybride tel que revendiqué dans la revendication 1, **caractérisé en ce que** ledit moteur/générateur électrique et ladite unité électronique de puissance sont connectés et fixés l'un(e) à l'autre pour former une première unité, et où ladite connexion est ledit premier point de fixation formé par une connexion enfichable (10, 23, 33, 34).

**3.** Groupe motopropulseur de véhicule hybride tel que revendiqué dans la revendication 2, **caractérisé en ce que** ladite unité électronique de puissance est également fixée audit premier côté de transmission par l'intermédiaire d'au moins un deuxième point de fixation (11, 13, 14, 15, 35, 36) réalisé en un matériau à faible conductance thermique.

**4.** Groupe motopropulseur de véhicule hybride tel que revendiqué dans la revendication 2, **caractérisé en ce que** ladite connexion enfichable est agencée pour transmettre au moins l'un parmi un agent de refroidissement pour ledit agencement de refroidissement et une puissance électrique entre ledit moteur/générateur et ladite unité électronique de puissance ou les deux à la fois.

**5.** Groupe motopropulseur de véhicule hybride tel que revendiqué dans la revendication 2, **caractérisé en ce que** ladite plaque d'unité électronique de puissance (12, 31, 32, 37, 38) est agencée pour couvrir ledit premier côté de transmission de façon à atténuer un bruit provenant de ladite transmission.

**6.** Groupe motopropulseur de véhicule hybride tel que revendiqué dans la revendication 3, **caractérisé en ce que** ledit deuxième point de fixation (11, 35, 36) s'étend autour de la périphérie d'un côté de ladite unité électronique de puissance faisant face à la transmission, et où ledit premier côté de transmission, ledit côté d'unité électronique de puissance et ledit deuxième point de fixation enveloppent un compartiment comprenant un milieu à faible conductance thermique et à haute capacité d'atténuation de bruit.

**7.** Groupe motopropulseur de véhicule hybride tel que revendiqué dans la revendication précédente, **caractérisé en ce que** lesdits premier et deuxième points de fixation sont réalisés en un matériau à haute capacité d'atténuation de bruit.

**8.** Groupe motopropulseur de véhicule hybride tel que revendiqué dans l'une des revendications 6 ou 7, **caractérisé en ce que** ladite plaque d'unité électronique de puissance comprend ladite unité électronique de puissance (38) avec un matériau d'atténuation de bruit et dans une partie étendue (37) seulement d'un matériau d'atténuation de bruit, ladite partie étendue étant agencée afin de mieux couvrir ledit premier côté de transmission.

**9.** Groupe motopropulseur de véhicule hybride tel que revendiqué dans la revendication 2, **caractérisé en ce qu'**un deuxième moteur/générateur électrique (28) avec une deuxième unité électronique de puissance (31) sont agencés en connexion avec ladite transmission (27) et qui forment ensemble une deuxième unité par l'intermédiaire d'une deuxième connexion enfichable (33), et où ladite deuxième unité électronique de puissance est agencée le long d'un deuxième côté de transmission dudit carter de transmission.

**10.** Groupe motopropulseur de véhicule hybride tel que revendiqué dans l'une des revendications 3 ou 4, où un tuyau flexible (15) permettant une transmission de l'agent de refroidissement est relié à ladite unité électronique de puissance essentiellement sur un côté opposé d'un endroit où ladite connexion enfichable (10) est agencée, **caractérisé en ce que** ledit deuxième point de fixation est formé d'une partie dudit tuyau flexible (15) et d'un porte-tuyau flexible de refroidissement (14) destiné à porter ledit tuyau flexible, et où ledit porte-tuyau flexible est fixé audit carter de transmission.

**11.** Groupe motopropulseur de véhicule hybride tel que revendiqué dans la revendication 1, **caractérisé en ce que** ladite unité électronique de puissance est fixée seulement audit premier côté de transmission avec au moins l'un desdits premiers points de fixation (39, 59).

**12.** Groupe motopropulseur de véhicule hybride tel que revendiqué dans la revendication précédente, **caractérisé en ce que** ledit premier point de fixation est d'un type vis-écrou, avec une section en coupe transversale relativement petite.

**13.** Groupe motopropulseur de véhicule hybride tel que revendiqué dans l'une des revendications 11 ou 12, **caractérisé en ce qu'**un deuxième point de fixation (42) s'étend autour de la périphérie d'un côté de ladite unité électronique de puissance faisant face à la transmission, et où ledit premier côté de transmission, ledit côté d'unité électronique de puissance et ledit deuxième point de fixation enveloppent un compartiment comprenant un milieu à faible conductance thermique et à haute capacité d'atténuation de bruit.

**14.** Groupe motopropulseur de véhicule hybride tel que revendiqué dans l'une des revendications 11 à 13, où un tuyau flexible permettant une transmission de l'agent de refroidissement est relié à ladite unité électronique de puissance essentiellement sur un côté opposé d'un endroit où ledit premier point de fixation (59) est agencé, **caractérisé en ce qu'**un troisième point de fixation est formé d'une partie (55) dudit tuyau flexible et d'un porte-tuyau flexible de refroidissement (54) destiné à porter ledit tuyau flexible, et où ledit porte-tuyau flexible est fixé audit carter de transmission.

**15.** Groupe motopropulseur de véhicule hybride tel que revendiqué dans l'une des revendications précédentes, **caractérisé en ce que** ledit groupe motopropulseur de véhicule hybride est un groupe motopropulseur de véhicule électrique hybride à configuration en parallèle.

Fig. 1a

Fig. 1b

Fig. 2a

Fig. 2b

Fig. 3

Fig. 4

Fig. 5

Fig. 6

Fig. 7

Fig. 8a

Fig. 8b

Fig. 9

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5343970 A
- US 20040134695 A
- WO 2004037594 A